# EUROPÄISCHE PATENTSCHRIFT

(11) **EP 1 118 122 B1**
(45) Veröffentlichungstag und Bekanntmachung des Hinweises auf die Patenterteilung: **19.08.2009**
(21) Anmeldenummer: 99955707.7
(22) Anmeldetag: 14.09.1999
(51) Int. Cl.: H01L 23/522

(54) **INTEGRIERTE SCHALTUNGSANORDNUNG UND VERFAHREN ZU DEREN HERSTELLUNG**
INTEGRATED CIRCUIT AND METHOD FOR PRODUCING THE SAME
CIRCUIT INTEGRE ET SON PROCEDE DE PRODUCTION

(30) Priorität: 23.09.1998 DE 19843624
(43) Veröffentlichungstag der Anmeldung: 25.07.2001
(73) Patentinhaber: Infineon Technologies AG, 81669 München (DE)
(72) Erfinder: ENGELHARDT, Manfred, D-83620 Feldkirchen-Westerham (DE)
(74) Vertreter: Kindermann, Peter
(86) Internationale Anmeldenummer: PCT/DE1999/002927
(87) Internationale Veröffentlichungsnummer: WO 2000/017928

(56) Entgegenhaltungen:
- EP-A- 0 798 778
- US-A- 5 308 793
- US-A- 5 612 254

## Beschreibung

Die Erfindung betrifft eine integrierte Schaltungsanordnung, die insbesondere unter Verwendung von Kupfer als leitendem Material realisierbar ist.

Es werden zunehmend neue Materialien für den künftigen Einsatz in integrierten Schaltungsanordnungen untersucht. Unter anderem wird Kupfer als leitendes Material untersucht.

Bei diesen neuen Materialien tritt mitunter das Problem auf, daß Halbleiterscheiben, insbesondere Siliziumscheiben, mit diesem Material kontaminiert werden.

Es ist daher vorgeschlagen worden (siehe zum Beispiel M. Woo et al, 1998 Symp. VLSI Technology Digest of Technical Papers, Seiten 12 bis 13, oder L. Su et al, 1998 Symp. VLSI Technology Digest of Technical Papers, Seiten 18 bis 19), in integrierten Schaltungen, die Kupfer als leitendes Material enthalten, zwischen derartigen leitenden Strukturen aus Kupfer und dem Halbleitersubstrat eine isolierende Diffusionsbarriere vorzusehen und im Bereich von Kontakten der leitenden Struktur zum Halbleitersubstrat eine leitende Barriere vorzusehen. Durch diese Barrieren soll eine Diffusion von dem kontaminierenden leitenden Material der leitenden Struktur zum Halbleitersubstrat vermieden werden.

Ferner ist vorgeschlagen worden, oberhalb derartiger leitender Strukturen aus Kupfer Diffusionsbarrieren vorzusehen, die eine Diffusion des Kupfers in dielektrische Schichten, die als sogenanntes Intermetalldielektrikum zwischen verschiedenen Metallisierungsebenen verwendet werden, verhindern.

Zur Herstellung einer integrierten Schaltung mit zwei Ebenen leitender Strukturen aus Kupfer ist es bekannt (siehe zum Beispiel M. Woo et al, 1998 Symp. VLSI Technology Digest of Technical Papers, Seiten 12 bis 13 oder L. Su et al, 1998 Symp. VLSI Technology Digest of Technical Papers, Seiten 18 bis 19) zunächst die untere Ebene leitender Strukturen aus Kupfer zu bilden. Diese untere Ebene ist gegen das Halbleitersubstrat durch Diffusionsbarriereschichten getrennt, wobei im Bereich von Kontakten leitende Diffusionsbarrieren verwendet werden. Auf die untere Metallisierungsebene wird ganzflächig eine isolierende Diffusionsbarriereschicht aufgebracht und darauf eine weitere dielektrische Schicht, in der Kontaktlöcher zu den leitenden Strukturen der unteren Metallisierungsebene geöffnet werden. Anschließend wird zunächst eine elektrisch leitende Barriere aufgebracht. Danach werden die Kontaktlöcher mit Kupfer gefüllt.

Es hat sich gezeigt, daß es auch in dieser Struktur zu einer Kontamination der dielektrischen Schicht durch Kupfer kommt.

Die US 5 612 254 und die EP0 798 778 offenbaren integrierte Schaltungsanordnungen und Verfahren zu deren Herstellung.

Der Erfindung liegt daher das Problem zugrunde, eine integrierte Schaltungsanordnung anzugeben, die mindestens zwei leitende Strukturen aufweist und in der eine Diffusion des Materials der leitenden Strukturen in umgebendes Material vermieden wird. Ferner soll ein Verfahren zur Herstellung einer derartigen integrierten Schaltungsanordnung angegeben werden.

Das Problem wird erfindungsgemäß gelöst durch eine integrierte Schaltungsanordnung gemäß Anspruch 1 sowie ein Verfahren zu deren Herstellung gemäß Anspruch 6. Weitere Ausgestaltungen der Erfindung gehen aus den übrigen Ansprüchen hervor.

In der erfindungsgemäßen Schaltungsanordnung ist eine erste leitende Struktur vorgesehen, die in eine erste isolierende Schicht eingebettet ist. Oberhalb der ersten leitenden Struktur sind eine Diffusionsbarriereschicht und eine zweite isolierende Schicht angeordnet, in denen ein Kontaktloch vorgesehen ist, das auf die erste leitende Struktur reicht. Die Seitenwände des Kontaktlochs sind oberhalb der Diffusionsbarriereschicht mit Spacern versehen, die als Barriere gegen eine Diffusion des Materials der ersten leitenden Struktur in die zweite isolierende Schicht wirken und die bis auf die Oberfläche der Diffusionsbarriereschicht reichen. In dem Kontaktloch ist eine zweite leitende Struktur angeordnet, die mit der ersten leitenden Struktur leitend verbunden ist.

Zur Herstellung einer derartigen integrierten Schaltungsanordnung wird auf ein Substrat, das mindestens die erste isolierende Schicht mit der ersten leitenden Struktur aufweist, die Diffusionsbarriereschicht aufgebracht. Darauf wird die zweite isolierende Schicht aufgebracht. In der zweiten isolierenden Schicht wird oberhalb der ersten leitenden Struktur das Kontaktloch geätzt, in dem die Oberfläche der ersten leitenden Struktur mit der Diffusionsbarriereschicht bedeckt ist. Anschließend werden an den Seitenwänden des Kontaktlochs die Spacer gebildet, die als Barriere gegen eine Diffusion des Materials der ersten leitfähigen Struktur in die zweite isolierende Schicht wirken. Daraufhin wird das Kontaktloch bis auf die Oberfläche der ersten leitenden Struktur geöffnet und mit der zweiten leitenden Struktur versehen.

Da die Seitenwände des Kontaktlochs mit den Spacern, die eine Diffusionsbarrierewirkung haben, bedeckt werden, ehe die Oberfläche der ersten leitenden Struktur in dem Kontaktloch freigelegt wird, wird in dieser Schaltungsanordnung vermieden, daß beim Öffnen des Kontaktlochs eine Ablagerung von an der Oberfläche der ersten leitenden Struktur während des Öffnen des Kontaktloches abgetragenem Material auf den Seitenwänden der zweiten isolierenden Schicht erfolgt. Derartige Ablagerungen während des Kontaktlochätzens werden dafür verantwortlich gemacht, daß in den nach bekannten Verfahren hergestellten Schaltungsanordnungen trotz der Verwendung von Diffusionsbarrieren eine Kontamination der dielektrischen Schichten auftritt. In dem erfindungsgemäßen Verfahren kann eine derartige Ablagerung nur auf der Oberfläche der Spacer bzw. der Diffusionsbarriereschicht erfolgen. Da die Spacer und die Diffusionsbarriereschicht eine Diffusionsbarriere darstellen, wird eine Kontamination der zweiten isolierenden Schicht wirksam verhindert.

Vorzugsweise werden die Spacer aus elektrisch leitendem Material mit Diffusionsbarrierewirkung gebildet, da sich in diesem Fall der wirksame Leitungsquerschnitt der zweiten leitenden Struktur um die Spacerquerschnittsfläche vergrößert.

Zur Vermeidung von Kurzschlüssen zwischen der ersten leitenden Struktur und benachbarten leitenden Strukturen ist es vorteilhaft, die Diffusionsbarriereschicht aus einem isolierendem Diffusionsbarrierematerial, insbesondere SiN oder SiON vorzusehen.

Die erfindungsgemäße Schaltungsanordnung sowie das Verfahren zu deren Herstellung ist vorteilhaft anwendbar beim Einsatz von Materialien für die erste leitende Struktur und/oder die zweite leitende Struktur, die eine hohe Diffusion in benachbartes Material aufweisen. Insbesondere ist die Schaltungsanordnung und das Verfahren zu deren Herstellung vorteilhaft anwendbar bei Verwendung von Kupfer, Silber, Gold, Platin oder Palladium für die erste leitende Struktur und/oder die zweite leitende Struktur.

Für die Spacer sind alle Materialien mit Diffusionsbarrierewirkung geeignet, insbesondere SiN, SiON, Ta, TaN oder Ti oder TiN geeignet, wobei im Hinblick auf den Leitungsquerschnitt leitfähige Materialien vorzuziehen sind.

Vorzugsweise grenzt die erste leitende Struktur an eine erste Diffusionsbarrierestruktur an, die elektrisch leitend ist und die mindestens unterhalb und seitlich der ersten leitenden Struktur angeordnet ist und die als Barriere gegen eine Diffusion des Materials der ersten leitenden Struktur in benachbartes Material wirkt. Für die erste Diffusionsbarrierestruktur ist insbesondere Ta, TaN, Ti oder TiN geeignet.

Ferner ist es vorteilhaft, unterhalb der zweiten leitenden Struktur eine zweite Diffusionsbarrierestruktur vorzusehen, die elektrisch leitend ist und die unterhalb an die zweite leitende Struktur angrenzt und als Barriere gegen eine Diffusion des Materials der zweiten leitenden Struktur wirkt. Auch für die zweite Diffusionsbarrierestruktur sind insbesondere Ta, TaN, Ti oder TiN geeignet.

Im folgenden wird die Erfindung anhand eines Ausführungsbeispiels, das in den Figuren dargestellt ist, näher erläutert.
- Figur 1: zeigt einen Schnitt durch ein Substrat mit einer ersten isolierenden Schicht, in die eine erste leitende Struktur eingebettet ist, mit einer Diffusionsbarriereschicht, die die erste leitende Struktur bedeckt, und mit einer zweiten isolierenden Schicht, in der ein Kontaktloch bis auf die Oberfläche der Diffusionsbarriereschicht geöffnet ist.
- Figur 2: zeigt den Schnitt durch das Substrat nach Abscheidung einer konformen Barriereschicht.
- Figur 3: zeigt den Schnitt durch das Halbleitersubstrat nach Bildung von Spacern mit Diffusionsbarrierewirkung an den Seitenwänden des Kontaktloches.
- Figur 4: zeigt den Schnitt durch das Halbleitersubstrat nach Freilegen der Oberfläche der ersten leitenden Struktur innerhalb des Kontaktloches.
- Figur 5: zeigt den Schnitt durch das Halbleitersubstrat nach Bildung einer zweiten leitenden Struktur.

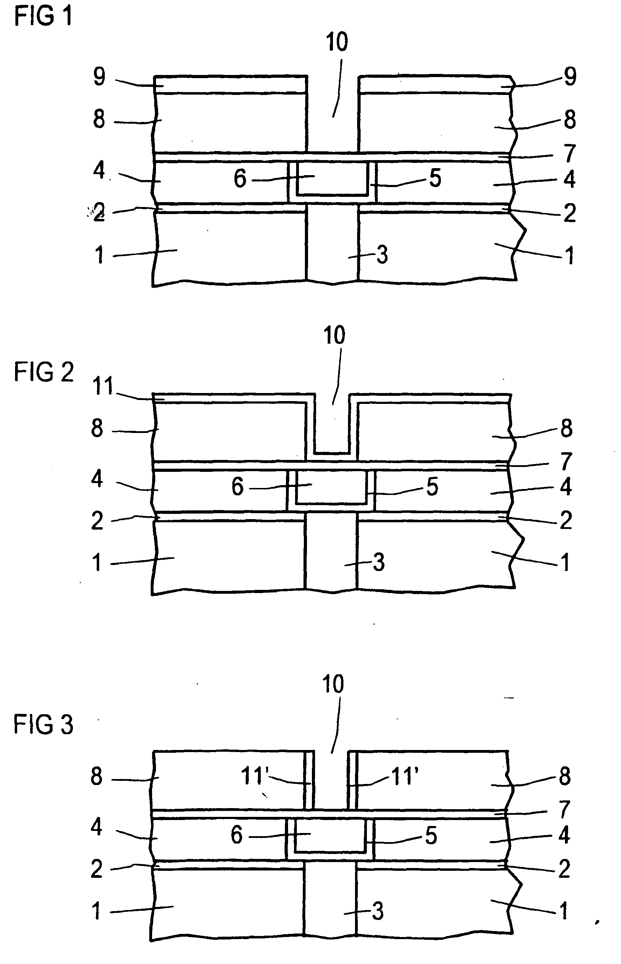

Ein Halbleitersubstrat weist mindestens eine Passivierungsschicht 1 und eine darauf angeordnete isolierende Diffusionsbarriereschicht 2 auf. Das Halbleitersubstrat umfaßt im wesentlichen monokristallines Silizium, die Passivierungsschicht 1 SiO₂ und die isolierende Diffusionsbarriereschicht 2 SiN. In der Passivierungsschicht 1 und der isolierenden Diffusionsbarriereschicht 2 ist ein Anschluß 3 aus Polysilizium oder Wolfram vorgesehen, der zur Kontaktierung eines im Halbleitersubstrat unterhalb der Passivierungsschicht 1 realisierten Bauelementes vorgesehen ist (siehe Figur 1).

Auf die Oberfläche der isolierenden Barriereschicht 2 wird eine erste isolierende Schicht 4 aus SiO₂ oder einem organischen oder anorganischen Material mit einer geringeren Dielektrizitätskonstante als SiO₂, das in der Fachwelt als low k Material bezeichnet wird und für das Polyimid oder Stoffe mit der Handelsbezeichnung PBO, BCB, Flowfill oder Silk geeignet sind, in einer Schichtdicke von 0,1 µm bis 2 µm aufgebracht. In der ersten isolierenden Schicht 4 wird durch Bildung einer Öffnung, Abscheidung einer ersten leitfähigen Barriereschicht aus Ta und Abscheidung einer Kupferschicht sowie nachfolgendes chemisch-mechanisches Polieren bis zum Freilegen der Oberfläche der ersten isolierenden Schicht 4 eine erste Diffusionsbarrierestruktur 5 und eine erste leitende Struktur 6 gebildet. Die erste Diffusionsbarrierestruktur 5 grenzt an die Seiten und den Boden der ersten leitenden_Struktur 6 an. Sie verhindert eine Diffusion des Kupfers der ersten leitenden Struktur 6 in die erste isolierende Schicht 4 sowie in den darunterliegenden Anschluß 3 und über diesen in das Halbleitersubstrat. Die erste leitende Struktur 6 ist in die erste isolierende Schicht 4 eingebettet.

Nachfolgend wird eine erste Diffusionsbarriereschicht 7 aus SiN in einer möglichst geringen Schichtdicke von typisch < 100 nm, vorzugsweise 10 bis 50 nm, aufgebracht. Auf die Diffusionsbarriereschicht 7 wird eine zweite isolierende Schicht 8 aus SiO₂ oder einem low k Material in einer Schichtdicke von 0,1 µm bis 2 µm aufgebracht. Mit Hilfe einer Ätzmaske 9 wird in einem Plasmaätzprozeß ein Kontaktloch 10 geöffnet, das oberhalb der ersten leitenden Struktur 6 angeordnet ist und das bis auf die Oberfläche der Diffusionsbarriereschicht 7 reicht.

Falls die zweite isolierende Schicht 8 aus SiO₂ besteht, wird die Ätzmaske 9 aus Photolack, Polyimid oder Photoimid gebildet und der Plasmaätzprozeß unter Verwendung eines CF₄, CHF₃ und/oder C₄F₈ enthaltenden Ätzgases durchgeführt.

Falls die zweite isolierende Schicht 8 aus low k Material besteht, wird die Ätzmaske 9 aus SiO₂, SiN oder SiON gebildet und der Plasmaätzprozeß mit einem 0₂ enthaltenden Ätzgas unter Zugabe von N₂, CF₄ oder ähnlichem durchgeführt.

Nach Entfernen der Ätzmaske 9 mit wird eine konforme Diffusionsbarriereschicht 11 aus Ta durch PVD (Physical Vapor deposition) oder CVD (Chemical Vapor deposition) in einer Schichtdicke von 10 bis 50 nm abgeschieden (siehe Figur 2).

Durch anisotropes Ätzen mit Fluor-Chemie (CF₄, CHF₃, zum Beispiel CF₄ + O₂) werden aus der konformen Barriereschicht 11 an den Seitenwänden des Kontaktloches 10 Spacer 11' gebildet. Die Spacer 11' bestehen aus TaN und weisen eine Diffusionsbarrierewirkung gegen Kupfer auf (siehe Figur 3). Die Spacer 11' reichen bis auf die Oberfläche der ersten Diffusionsbarriereschicht 7.

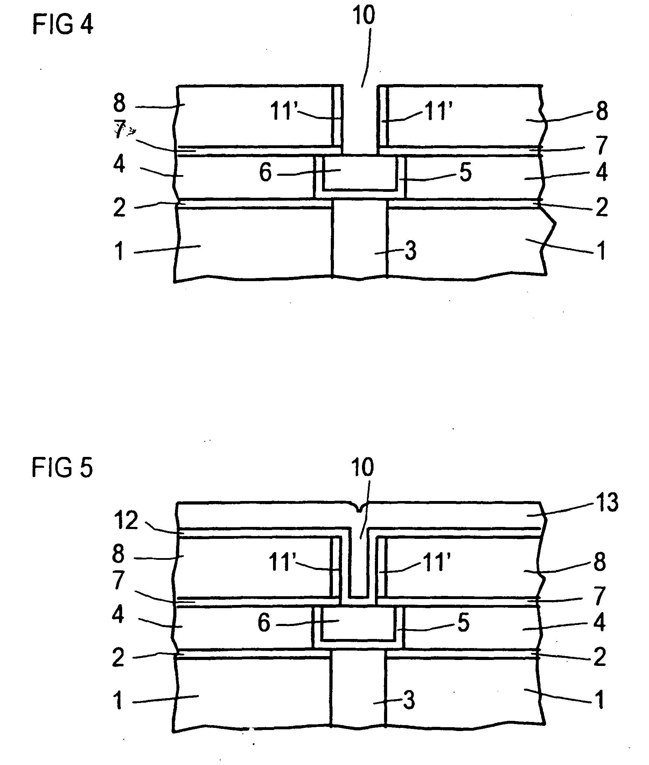

Durch anisotropes Ätzen mit Fluor-Chemie wird die Diffusionsbarriereschicht 7 strukturiert, so daß das Kontaktloch 10 bis auf die Oberfläche der ersten leitenden Struktur 6 reicht. Bei diesem Ätzschritt ist die dem Kontaktloch zugewandte Oberfläche der zweiten isolierenden Schicht 8 mit den Spacern 11' bedeckt, so daß eine Ablagerung von an der Oberfläche der ersten leitenden Struktur 6 abgetragenem Material auf die Flanken der zweiten isolierenden Schicht 8, die dem Kontaktloch 10 zugewandt sind, vermieden wird (siehe Figur 4). Alternativ können die Ätzung der Spacer 11' und die Strukturierung der Diffuionsbarrierschicht 7 in einem Ätzschritt durchgeführt werden.

Anschließend wird eine zweite leitende Diffusionsbarriereschicht abgeschieden, die die Oberfläche der zweiten isolierenden Schicht 8, die Spacer 11' und die freiliegende Oberfläche der ersten leitenden Struktur 6 bedeckt. Die zweite leitende Diffusionsbarriereschicht wird in einer Schichtdicke von 10 nm bis 50 nm aus TaN durch eine PVD- oder CVD-Abscheidung gebildet. Durch Abscheidung einer weiteren Kupferschicht, die den verbliebenen Freiraum in dem Kontaktloch 10 auffüllt, und Strukturierung der Kupferschicht und der darunter angeordneten zweiten leitenden Diffusionsbarriereschicht werden eine zweite Diffusionsbarriereschicht 12 und eine zweite leitende Struktur 13 gebildet, die mit der ersten leitenden Struktur 6 leitend verbunden ist (siehe Figur 5). Die zweite leitende Struktur 13 ist als Leiterbahn einer Metallisierungsebene ausgestaltet.

## Patentansprüche

1. Integrierte Schaltungsanordnung,
bei der eine erste leitende Struktur (6) vorgesehen ist, die in einer isolierenden Schicht (4) eingebettet ist, bei der oberhalb der ersten leitenden Struktur (6) eine Diffusionsbarrierenschicht (7) und eine zweite isolierende Schicht (8) angeordnet sind, in denen ein Kontaktloch (10) vorgesehen ist, das auf die erste leitende Struktur (6) reicht,
bei der im Kontaktloch (10) eine zweite leitende Struktur (13) angeordnet ist, die mit der ersten leitenden Struktur (6) leitend verbunden ist, und
bei der eine Ablagerung von an der Oberfläche der ersten leitenden Struktur (6) während des Öffnen des Kontaktlochs (10) abgetragenem Material vorhanden ist,
**dadurch gekennzeichnet, dass**
die Seitenwände des Kontaktlochs (10) oberhalb der Diffusionsbarrierenschicht (7) mit Spacern (11') versehen sind, die als Barriere gegen eine Diffusion besagter Ablagerung in die zweite isolierende Schicht (8) wirken und die bis auf die Oberfläche der Diffusionsbarriereschicht (7) reichen.

2. Schaltungsanordnung nach Anspruch 1,
bei der die Spacer (11') elektrisch leitend sind.

3. Schaltungsanordnung nach Anspruch 1 oder 2,
bei der die erste leitende Struktur (6) an eine erste Diffusionsbarrierestruktur (5) angrenzt, die elektrisch leitend ist und die mindestens unterhalb und seitlich der ersten leitenden Struktur (6) angeordnet ist und die als Barriere gegen eine Diffusion des Materials der ersten leitenden Struktur (6) wirkt.

4. Schaltungsanordnung nach einem der Ansprüche 1 bis 3,
bei der die zweite leitende Struktur (13) an eine zweite Diffusionsbarrierestruktur (12) angrenzt, die elektrisch leitend ist und mindestens unterhalb der zweiten leitenden Struktur (13) angeordnet ist und die als Barriere gegen eine Diffusion des Materials der zweiten leitenden Struktur (13) wirkt.

5. Schaltungsanordnung nach einem der Ansprüche 1 bis 4,
- bei die erste leitende Struktur (6) und/oder die zweite leitende Struktur (13) Kupfer, Silber, Gold, Platin oder Palladium enthält,
- bei der die Spacer (11') und/oder die erste Diffusionsbarrierestruktur (5) und/oder die zweite Diffusionsbarrierestruktur (12) Ta, TaN, Ti oder TiN enthalten,
- bei der die Diffusionsbarriereschicht (7) und/oder die Spacer (11') SiN oder SiON enthalten.

6. Verfahren zur Herstellung einer integrierten Schaltungsanordnung mit der Reihenfolge von Schritten, dass
- auf ein Substrat (1, 2, 3), das mindestens eine erste isolierende Schicht (4) aufweist, in die eine erste leitende Struktur (6) eingebettet ist, eine Diffusionsbarriereschicht (7) aufgebracht wird,
- auf die Diffusionsbarriereschicht (7) eine zweite isolierende Schicht (8) aufgebracht wird,
- in die zweite isolierende Schicht (8) oberhalb der ersten leitenden Struktur (6) ein Kontaktloch (10) geätzt wird, in dem die Oberfläche der ersten leitenden Struktur (6) mit der Diffusionsbarriereschicht (7) bedeckt ist,
- an den Seitenwänden des Kontaktlochs (10) Spacer (11') gebildet werden,
- das Kontaktloch (10) bis auf die Oberfläche der ersten leitenden Struktur (6) geöffnet wird und dabei eine Ablagerung von an der Oberfläche der ersten leitenden Struktur (6) abgetragenem Material erstellt, und
- in dem Kontaktloch (10) eine zweite leitende Struktur (13) gebildet wird, die mit der ersten leitenden Struktur (6) leitend verbunden ist, wobei besagte Spacer (11') als Barriere gegen Diffusion bezagter Ablagerung in die zweite isolierende Schicht (8) wirken.

7. Verfahren nach Anspruch 6,
bei dem die Spacer (11') aus elektrisch leitendem Material gebildet werden.

8. Verfahren nach Anspruch 6 oder 7,
- bei dem zur Herstellung der ersten elektrisch leitenden Struktur (6) auf das Substrat (1, 2, 3) die erste isolierende Schicht (4) aufgebracht wird,
- bei dem in der ersten isolierenden Schicht (4) eine Öffnung erzeugt wird,
- bei dem durch Abscheiden und Strukturieren einer ersten leitenden Barriereschicht eine erste Diffusionsbarrierestruktur (5) gebildet wird, die elektrisch leitend ist und die den Boden und die Seitenwände der Öffnung bedeckt,
- bei dem die erste leitende Struktur (6) durch Auffüllen der Öffnung mit leitendem Material gebildet wird.

9. Verfahren nach einem der Ansprüche 6 bis 8,
- bei dem nach der Öffnung des Kontaktloches (10) bis auf die Oberfläche der ersten leitenden Struktur (6) eine zweite leitende Barriereschicht abgeschieden wird,
- bei dem eine leitende Schicht abgeschieden wird,
- bei dem durch Strukturierung der leitenden Schicht und der zweiten leitenden Barriereschicht die zweite leitende Struktur (13) und eine darunter angeordnete zweite Diffusionsbarrierestruktur (12) gebildet werden.

10. Verfahren nach einem der Ansprüche 6 bis 9,
- bei dem die erste leitende Struktur (6) und/oder die zweite leitende Struktur (13) Kupfer, Silber, Gold, Platin oder Palladium enthalten,
- bei dem die Spacer (11') und/oder die erste Diffusionsbarrierestruktur (5) und/oder die zweite Diffusionsbarrierestruktur (12) Ta; TaN, Ti oder TiN enthalten,
- bei dem die Diffusionsbarriereschicht (7) und/oder die Spacer (11') SiN oder SiON enthalten.

## Claims

1. Integrated circuit arrangement,
in which a first conductive structure (6) is provided, which is embedded in an insulating layer (4), in which, above the first conductive structure (6) there are arranged a diffusion barrier layer (7) and a second insulating layer (8), in which a contact hole (10) is provided which reaches as far as the first conductive structure (6),
in which a second conductive structure (13), which is conductively connected to the first conductive structure (6), is arranged in the contact hole (10), and
in which there is a deposition of material removed at the surface of the first conductive structure (6) during the opening of the contact hole (10)
**characterized in that,**
above the diffusion barrier layer (7), the side walls of the contact hole (10) are provided with spacers (11'), which act as a barrier to diffusion of said deposition into the second insulating layer (8) and which reach as far as the surface of the diffusion barrier layer (7).

2. Circuit arrangement according to Claim 1, in which the spacers (11') are electrically conductive.

3. Circuit arrangement according to Claim 1 or 2, in which the first conductive structure (6) adjoins a first diffusion barrier structure (5), which is electrically conductive and which is arranged at least beneath and to the side of the first conductive structure (6) and which acts as a barrier to diffusion of the material from the first conductive structure (6).

4. Circuit arrangement according to one of Claims 1 to 3, in which the second conductive structure (13) adjoins a second diffusion barrier structure (12), which is electrically conductive and is arranged at least beneath the second conductive structure (13) and which acts as a barrier to diffusion of the material from the second conductive structure (13).

5. Circuit arrangement according to one of Claims 1 to 4,
- in which the first conductive structure (6) and/or the second conductive structure (13) contains copper, silver, gold, platinum or palladium,
- in which the spacers (11') and/or the first diffusion barrier structure (5) and/or the second diffusion barrier structure (12) contain Ta, TaN, Ti or TiN,
- in which the diffusion barrier layer (7) and/or the spacers (11') contain SiN or SiON.

6. Method of producing an integrated circuit arrangement, having the sequence of steps that
- a diffusion barrier layer (7) is applied to a substrate (1, 2, 3) which has at least a first insulating layer (4) in which a first conductive structure (6) is embedded,
- a second insulating layer (8) is applied to the diffusion barrier layer (7),
- a contact hole (10) is etched into the second insulating layer (8) above the first conductive structure (6), in which hole the surface of the first conductive structure (6) is covered with the diffusion barrier layer (7),
- on the side walls of the contact hole (10), spacers (11') are formed,
- the contact hole (10) is opened as far as the surface of the first conductive structure (6), and in the process a deposition of material removed at the surface of the first conductive structure (6) arises, and
- in the contact hole (10), a second conductive structure (13) is formed, which is conductively connected to the first conductive structure (6), said spacers (11') acting as a barrier to diffusion of said deposition into the second insulating layer (8).

7. Method according to Claim 6, in which the spacers (11') are formed of electrically conductive material.

8. Method according to Claim 6 or 7,
- in which, in order to produce the first electrically conductive structure (6), the first insulating layer (5) is applied to the substrate (1, 2, 3),
- in which an opening is produced in the first insulating layer (4),
- in which, by depositing and structuring a first conductive barrier layer, a first diffusion barrier structure (5) is formed which is electrically conductive and which covers the bottom and the side walls of the opening,
- in which the first conductive structure (8) is formed by filling the opening with conductive material.

9. Method according to one of Claims 6 to 8,
- in which, after the contact hole (10) has been opened as far as the surface of the first conductive structure (6), a second conductive barrier layer is deposited,
- in which a conductive layer is deposited,
- in which, by structuring the conductive layer and the second conductive barrier layer, the second conductive structure (13) and a second diffusion barrier structure (12) arranged underneath the latter are formed.

10. Method according to one of Claims 6 to 9,
- in which the first conductive structure (6) and/or the second conductive structure (13) contain copper, silver, gold, platinum or palladium,
- in which the spacers (11') and/or the first diffusion barrier structure (5) and/or the second diffusion barrier structure (12) contain Ta, TaN, Ti or TiN,
- in which the diffusion barrier layer (7) and/or the spacers (11') contain SiN or SiON.

## Revendications

1. Circuit intégré,
dans lequel il est prévu une première structure (6) conductrice qui est incorporée dans une couche (4) isolante,
dans lequel, au-dessus de la première structure (6) conductrice, sont disposées une couche (7) formant barrière de diffusion et une deuxième couche (8) isolante, dans lesquelles est prévu un trou (10) de contact qui va jusqu'à la première structure (6) conductrice,
dans lequel il est disposé dans le trou (10) de contact une deuxième structure (13) conductrice qui est reliée d'une manière conductrice à la première structure (6) conductrice, et
dans lequel il est prévu un dépôt de matière enlevée à la surface de la première structure (6) conductrice pendant l'ouverture du trou (10) de contact,
**caractérisé en ce que**
les parois latérales du trou (10) de contact sont munies, au dessus de la couche (7) formant barrière de diffusion, d'espaceurs (11') qui servent de barrière à l'encontre d'une diffusion dudit dépôt dans la deuxième couche (8) isolante et qui vont jusqu'à la surface de la couche (7) formant barrière de diffusion.

2. Circuit suivant la revendication 1,
dans lequel les espaceurs (11') sont conducteurs de l'électricité.

3. Circuit suivant la revendication 1 ou 2,
dans lequel la première structure (6) conductrice est voisine d'une première structure (5) formant barrière de diffusion, qui est conductrice de l'électricité et qui est disposée au moins en dessous de la première structure (6) conductrice et latéralement à celle-ci et qui sert de barrière à l'encontre d'une diffusion de la matière de la première structure (6) conductrice.

4. Circuit suivant l'une des revendications 1 à 3,
dans lequel la deuxième structure (13) conductrice est voisine d'une deuxième structure (12) formant barrière de diffusion qui est conductrice de l'électricité et qui est disposée au moins en dessous de la deuxième structure (13) conductrice et qui sert de barrière à l'encontre d'une diffusion de la matière de la deuxième structure (13) conductrice.

5. Circuit suivant l'une des revendications 1 à 4,
- dans lequel la première structure (6) conductrice et/ou la deuxième structure (13) conductrice contiennent du cuivre, de l'argent, de l'or, du platine ou du palladium,
- dans lequel les espaceurs (11') et/ou la première structure (5) formant barrière de diffusion et/ou la deuxième structure (12) formant barrière de diffusion contiennent du Ta, du TaN, du Ti, ou du TiN,
- dans lequel la couche (7) formant barrière de diffusion et/ou les espaceurs (11') contiennent du SiN ou du SiON.

6. Procédé de fabrication d'un circuit intégré ayant la succession des stades dans lesquels
- on dépose une couche (7) formant barrière de diffusion sur un substrat (1, 2, 3) qui a au moins une couche (4) isolante dans laquelle est incorporée une première structure (6) conductrice,
- on dépose une deuxième couche (8) isolante sur la couche (7) formant barrière de diffusion,
- on ménage par attaque un trou (10) de contact dans la deuxième couche (8) isolante au dessus de la première structure (6) conductrice, trou dans lequel la surface de la première structure (6) conductrice est recouverte de la couche (7) formant barrière de diffusion,
- on forme des espaceurs (11') sur les parois latérales du trou (10) de contact,
- on ouvre le trou (10) de contact jusqu'à la surface de la première structure (6) conductrice et on crée ainsi un dépôt de matière enlevée de la surface de la première structure (6) conductrice, et
- on forme dans le trou (10) de contact une deuxième structure (13) conductrice qui est reliée d'une manière conductrice à la première structure (6) conductrice, lesdits espaceurs (11') servant de barrière à l'encontre d'une diffusion dudit dépôt dans la deuxième couche (8) isolante.

7. Procédé suivant la revendication 6,
dans lequel on forme les espaceurs (11') en une matière conductrice de l'électricité.

8. Procédé suivant la revendication 6 ou 7,
- dans lequel pour fabriquer la première structure (6) conductrice d'électricité, on dépose la première couche (4) isolante sur le substrat (1, 2, 3),
- dans lequel on produit une ouverture dans la première couche (4) isolante,
- dans lequel par dépôt et par structuration d'une première couche conductrice formant barrière, on forme une première structure (5) formant barrière de diffusion, qui est conductrice de l'électricité et qui recouvre le fond et les parois latérales de l'ouverture,
- dans lequel on forme la première structure (6) conductrice en remplissant l'ouverture de matière conductrice.

9. Procédé suivant l'une des revendications 6 à 8,
- dans lequel, après l'ouverture du trou (10) de contact jusqu'à la surface de la première structure (6) conductrice, on dépose une deuxième couche conductrice formant barrière,
- dans lequel on dépose une couche conductrice,
- dans lequel on forme par structuration de la couche conductrice et de la deuxième couche conductrice formant barrière la deuxième structure (13) conductrice et une deuxième struc-turé (12) formant barrière de diffusion sous-jacente.

10. Procédé suivant l'une des revendications 6 à 9,
- dans lequel la première structure (6) conductrice et/ou la deuxième structure (13) conductrice contiennent du cuivre, de l'argent, de l'or, du platine ou du palladium,
- dans lequel les espaceurs (11') et/ou la première structure (5) formant barrière de diffusion et/ou la deuxième structure (12) formant barrière de diffusion contiennent du Ta, du TaN, du Ti ou du TiN,
- dans lequel la couche (7) formant barrière de diffusion et/ou les espaceurs (11') contiennent du SiN ou du SiON.
